# EUROPEAN PATENT APPLICATION

(11) **EP 1 683 962 A1**
(43) Date of publication of application: **26.07.2006**
(21) Application number: 05077904.0
(22) Date of filing: 19.12.2005
(51) Int. Cl.: F02P 3/055, F02D 41/22

(54) **Circuit for protecting a transistor connected to the primary side of an ignition coil against an overvoltage resulting from an open circuit condition in the secondary side of the ignition coil**

(30) Priority: 07.01.2005 US 31245
(71) Applicant: Delphi Technologies, Inc., Troy, MI 48007 (US)
(72) Inventor: Nair, Balakrishnan V., Singapore 760 283 (SG); Downey, Joel F., Kokomo, IN 46901 (US)
(74) Representative: Denton, Michael John

(57) **Abstract**

An electronic circuit (10) for driving a load (12) includes a primary coil (18) coupled to a secondary coil (20). The secondary coil is coupled to the load. A switching device (28) is electrically connected to the primary coil. A control circuit (30) is coupled to the switching device and inhibits current flow through the switching device if an electrical signal applied to the switching device by the primary coil is indicative of the secondary coil being in an open condition.

## Description

### TECHNICAL FIELD

The present invention relates to a circuit for driving a coil system including a primary coil and a secondary coil, and, more particularly, to a circuit including a transistor for driving such a coil system.

### BACKGROUND OF THE INVENTION

Coil systems including a primary coil coupled to a secondary coil may be used in vehicle ignition systems wherein the secondary coil may drive a spark plug, for example. A switching device such as a transistor may be electrically connected to the primary coil in order to switch the current through the primary coil on and off. Circuitry may be provided for sensing a fault such as a short circuit or an open circuit condition in the primary coil. The switching device and sensing circuitry along with a processor and other components may be included in an engine control module (ECM).

A problem is that there is no circuitry provided for sensing an open circuit condition in the secondary coil. A secondary coil open circuit condition may result from a disconnect within the wire connecting the secondary coil to the spark plug, or from the gap within the plug itself being too big, for example. Such an open circuit in the secondary coil prevents the energy in the coils from being transmitted to the spark plug, and the energy may be transmitted to the transistor instead. Excess energy being transmitted to the transistor may cause the transistor to dissipate a level of power that is high enough to permanently damage the transistor. When the transistor or any other component of the ECM is damaged, it is common practice to replace the entire ECM, which may be very costly.

What is needed in the art is a circuit that is capable of detecting an open condition in a secondary coil and inhibiting current flow through a switching device connected to a primary coil before the switching device is damaged as a result of the open condition.

### SUMMARY OF THE INVENTION

The present invention provides a circuit for monitoring an electrical signal, such as a voltage signal or a current signal, that is applied to a switching device by a primary coil. If the voltage signal or current signal stays at a high level for longer period of time than it would under normal operating conditions, which may be indicative of an open condition in the secondary coil, the circuit prevents further current flow through the switching device, thereby preventing damage to the switching device.

The signal derived during the open secondary may be used to prevent future turning ON of the IGBT, so that the IGBT can be saved from permanent damage. This may be achieved through software.

In one embodiment, a comparator circuit monitors the collector voltage of a transistor that is connected in series with a primary ignition coil. When the secondary coil is in an open condition, voltage appearing across the collector of the transistor during the OFF-time of the transistor stays high for a longer period of time than if the secondary coil were not open. The longer time duration of the collector voltage could damage the transistor due to higher energy dissipation during that time. The comparator circuit includes a resistor-capacitor circuit having a time constant such that, if the duration of the increased collector voltage is longer than a threshold time value, a voltage input to a comparator exceeds a threshold voltage, which triggers the comparator to output a signal to a processor. In response to the signal, the processor refrains from applying voltage to the gate of the transistor, thereby preventing further current flow through the transistor and protecting the transistor from being damaged by further current flow.

In one form, the present invention comprises an electronic circuit for driving a load. The circuit includes a primary coil coupled to a secondary coil. The secondary coil is coupled to the load. A switching device is electrically connected to the primary coil. A control circuit is coupled to the switching device and inhibits current flow through the switching device if an electrical signal applied to the switching device by the primary coil is indicative of the secondary coil being in an open condition.

In another form, the present invention comprises an electronic circuit for driving a load. The circuit includes a primary coil coupled to a secondary coil. The secondary coil is coupled to the load. A switching device is electrically connected to the primary coil. A control circuit monitors a voltage and/or a current applied to the switching device by the primary coil. The control circuit inhibits current flow through the switching device if the voltage and/or current exceeds a threshold value for a period of time greater than a threshold period of time.

An advantage of the present invention is that an open condition in the secondary coil may be detected, and current flow through the switching device connected to the primary coil may be inhibited in response to the detection of the open condition, thereby preventing damage to the switching device from excess power.

### BRIEF DESCRIPTION OF THE DRAWINGS

The above-mentioned and other features and objects of this invention, and the manner of attaining them, will become more apparent and the invention itself will be better understood by reference to the following description of embodiments of the invention taken in conjunction with the accompanying drawings, wherein:
Figure 1 is a schematic diagram of one embodiment of an electronic circuit of the present invention and a load driven by the circuit;
Figure 2a is a simplified plot of the voltage at the collector of the transistor of Figure 1 versus time under normal operating conditions;
Figure 2b is a simplified plot of the voltage at the collector of the transistor of Figure 1 versus time when the secondary coil is in an open circuit condition; and
Figure 3 is a schematic diagram of another embodiment of an electronic circuit of the present invention and a load driven by the circuit.

Corresponding reference characters indicate corresponding parts throughout the several views. Although the drawings represent embodiments of the present invention, the drawings are not necessarily to scale and certain features may be exaggerated in order to better illustrate and explain the present invention. The exemplifications set out herein illustrate embodiments of the invention in several forms and such exemplification is not to be construed as limiting the scope of the invention in any manner.

### DESCRIPTION OF INVENTION

The embodiments discussed below are not intended to be exhaustive or limit the invention to the precise forms disclosed in the following detailed description. Rather, the embodiments are chosen and described so that others skilled in the art may utilize their teachings.

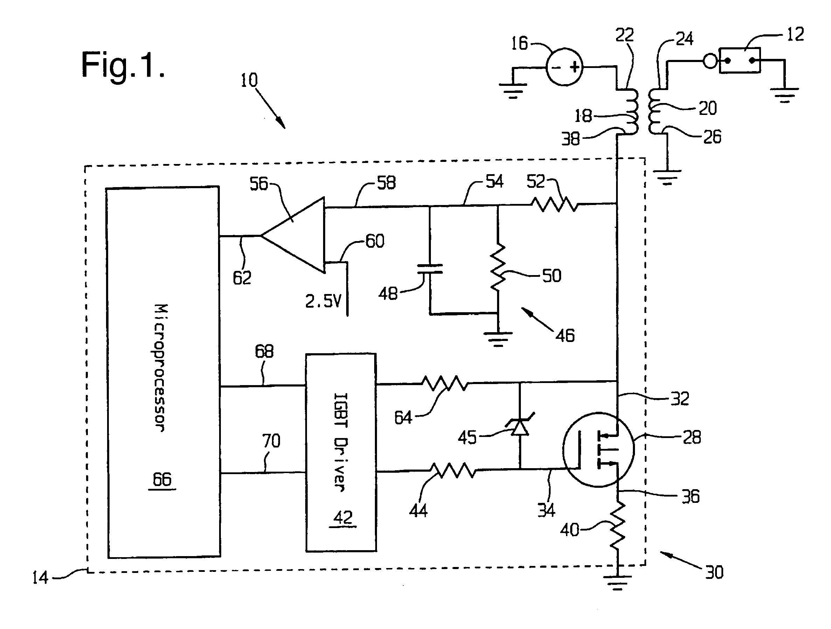

One embodiment of an electronic circuit 10 of the present invention for driving a load 12 is shown in Figure 1. In the embodiment shown, load 12 is in the form of a spark plug. Circuit 10 and plug 12 may be used, for example, in a vehicle ignition system.

Circuit 10 includes an ECM 14, a direct current (DC) power supply 16, a primary coil 18 and a secondary coil 20. As shown, power supply 16 applies a positive DC battery voltage, such as 16 volts or less, to a first end 22 of primary coil 18. Primary coil 18 is electrically coupled to secondary coil 20 such that a current through primary coil 18 may induce a corresponding current through, and voltage across, secondary coil 20. A first end 24 of secondary coil 20 is electrically connected to plug 12, and a second end 26 of secondary coil 20 is electrically grounded.

ECM 14 includes a transistor 28 and a control circuit 30 therefor. In the embodiment shown, transistor 28 is in the form of an insulated gate bipolar transistor (IGBT) having a collector 32, a gate 34, and an emitter 36. Collector 32 is electrically connected to a second end 38 of primary coil 18, emitter 36 is grounded through a resistor 40, and gate 34 is driven by an IGBT driver 42 through a resistor 44. A zener diode 45 may provide control of IGBT 28 when the collector voltage is greater than maximum voltage for IGBT 28.

A delay circuit 46 may be directly connected to second end 38 of primary coil 18 and to collector 32 such that delay circuit 46 receives a voltage signal applied to collector 32 by primary coil 18. Delay circuit 46 is in the form of a resistor capacitor circuit including a resistor 52 and the parallel combination of resistor 50 and capacitor 48. Resistors 50, 52 also function as a voltage divider for reducing the voltage at node 54 relative to the voltage signal received from second end 38 of primary coil 18. For example, resistor 52 may have a resistance approximately 100 times greater than the resistance of resistor 50 such that the voltage signal received from second end 38 of primary coil 18 is approximately 100 times greater than the voltage at node 54 at steady state.

An operational amplifier 56 set up as a comparator has a first input 58 that receives the delay voltage signal at node 54. A second input 60 of comparator 56 receives a threshold reference voltage which, in the embodiment shown, is approximately 2.5 volts. Comparator 56 may output a comparator signal at node 62 if the delay voltage signal at node 54 is greater than the threshold reference voltage of 2.5 volts. For example, in one embodiment, the comparator signal may be a DC voltage signal of approximately 5 volts and having a time duration corresponding to the time period in which the delay voltage signal at node 54 is greater than the threshold reference voltage of 2.5 volts. When the delay voltage signal at node 54 is not greater than the threshold reference voltage of 2.5 volts, comparator 56 may not output any signal, and the voltage at node 62 may be near zero volts, i.e., essentially grounded.

IGBT driver 42 may sense, via a resistor 64, the voltage applied to collector 32. IGBT driver 42 may also transmit to a microprocessor 66, on a node 68, a signal indicative of the voltage at collector 32. Microprocessor 66 may also receive the output signal from comparator 56 on node 62. In response to the signal received on node 62 and/or the signal received on node 68, microprocessor 66 may transmit a signal on node 70. In response to the signal on node 70, IGBT driver 42 may transmit a signal via resistor 44 to gate 34 in order to turn on or turn off IGBT 28.

During use, power supply 16 applies a voltage to collector 32 through primary coil 18. Microprocessor 66 may selectively apply a voltage signal to gate 34 via IGBT driver 42 and resistor 44 to thereby selectively allow current to flow through IGBT 28. More particularly, the application of voltage to gate 34 may allow current to flow from collector 32 to emitter 36, and the absence of voltage at gate 34 may prevent current from flowing from collector 32 to emitter 36.

The flow of current through IGBT 28, in turn, allows current to flow through primary coil 18. Primary coil 18 and 20 form a transformer. The typical turns ratio of the transformer is in the order of 80 to 100. When the transistor 28 is switched OFF after reaching the energization current, say 10 Amperes, the primary coil 18 develops a kick back voltage in the order of 380 to 430 volts. If secondary coil 20 is in good condition, i.e., there are no electrical discontinuities between plug 12 and ground, the basic transformer action induces a secondary voltage at coil 20 corresponding to 80 to 100 times the voltage developed across primary coil 18. This high voltage may cause a spark across the spark plug. Thus, the current interruption within coil 18 may result in a spark at plug 12.

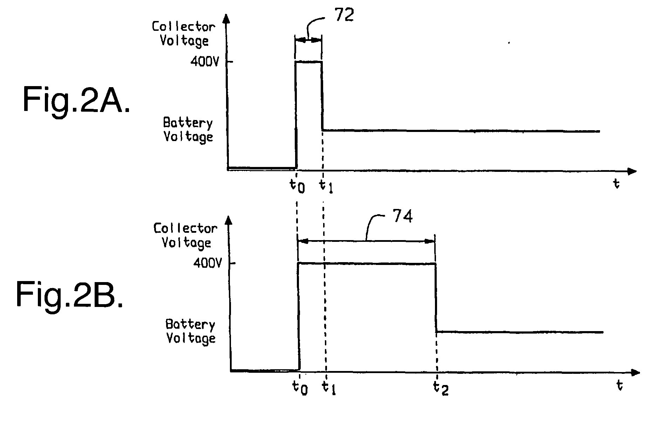

Figure 2a is an idealized plot of the voltage at collector 32 during a firing event when microprocessor 66 removes voltage from gate 34 and secondary coil 20 is in good condition. Before time to, voltage is applied to gate 34 and the voltage at collector 32 is relatively low, i.e., one to two volts. At time to, when voltage is removed from gate 34, the voltage at collector 32 spikes up from approximately one to two volts to a clamp voltage of approximately 400 volts, for example. As the energy in coils 18, 20 is transferred to plug 12, the voltage at collector 32 is maintained at 400 volts for a time period 72 of approximately between 5 and 10 microseconds before a spark occurs in plug 12 at time t₁, and the collector voltage falls back to battery voltage.

In actuality, the collector voltage may or may not reach a clamp voltage of 400 volts. Whether or not the collector voltage reaches the clamp voltage may be determined by a few factors, including the leakage inductance of the ignition coil, and the switching current fall time of IGBT 28. At the turn off of IGBT 28, two voltage waveforms may be superimposed at the collector. The first is the first half cycle of a sine function, primarily dominated by the leakage inductance of the ignition coil. This is the first "spike that is seen, and may have almost nothing to do with anything on the secondary of the ignition coil. After this spike falls, the reflection of the secondary voltage on the primary winding may be seen. If there is a breakdown of the spark plug gap, the peak voltage seen after the first spike may rarely exceed 350 volts.

If secondary coil 20 is in a partially or fully open condition, e.g., if the gap in plug 12 is too large, or there is a discontinuity in either coil 20, the wire from end 26 to ground, or the wire from end 24 to plug 12, then current may not flow through secondary coil 20. In this case, the power within coils 18, 20 may not be transferred to plug 12, but rather may be largely retained therein.

Figure 2b is an idealized plot of the voltage at collector 32 during a firing event when microprocessor 66 removes voltage from gate 34 and secondary coil 20 is in a partially or fully open condition. At time to, when voltage is removed from gate 34, the voltage at collector 32 may spike up from zero voltage to the clamp voltage of approximately 400 volts. Because the energy in coils 18, 20 cannot be dissipated by plug 12 when secondary coil 20 is in an open condition, the voltage at collector 32 is maintained at 400 volts for a longer time period 74, i.e., an avalanche time, of approximately between 50 and 140 microseconds before the collector voltage falls back to battery voltage at time t₂. Such an extended high voltage signal at collector 32 may be indicative of secondary coil 20 being in an open condition. In actuality, the collector voltage may undergo some ringing in which it may drop as low as -40 volts before settling at battery voltage.

If current is again allowed to flow through IGBT 28 by applying voltage to gate 34 during time period 74, there is significant risk of irreversible damage to IGBT 28. Thus, control circuit 30 may sense if the clamp voltage at collector 32 has a time duration that exceeds a threshold time period, such as 40 to 50 microseconds, and may, in response to the extended clamp voltage, refrain from turning on IGBT 28. More particularly, delay circuit 46, including the voltage divider provided by resistors 50, 52, produces a delay voltage signal that exceeds a threshold voltage only if the clamp voltage exceeds a threshold value and has a time duration that exceeds a threshold time period. Comparator 56 receives both the delay voltage signal and the threshold voltage. If the delay voltage signal does indeed exceed the threshold voltage, comparator 56 outputs a signal indicative thereof to microprocessor 66, which may then refrain from transmitting an ON signal to gate 34 via node 70, IGBT driver 42 and resistor 44 to thereby prevent IGBT 28 from turning on and to thereby protect IGBT 28 from high power damage. A signal on node 62 may be used to prevent further pulses to the IGBT. Signals at node 62 may appear only in an open secondary condition. Once microprocessor 66 detects a signal on node 62, software should prevent further pulsing on IGBT 28.

Resistor 52 may have a resistance that is approximately 100 times greater than that of resistor 50 such that, if the clamp voltage at collector 32 is 400 volts, then the steady state voltage at node 54 during clamp is approximately 400 volts/100, or 4 volts. The values of capacitor 48 and resistors 50, 52 may be selected such that the delay voltage signal at node 54 does not rise above the threshold voltage of 2.5 volts unless and/or until the clamp voltage signal has had a magnitude and time duration that could damage IGBT 28. For example, the values of capacitor 48 and resistors 50, 52 may be selected such that the delay voltage signal at node 54 does not rise above the threshold voltage of 2.5 volts unless and/or until the clamp voltage signal at collector 32 exceeds a threshold value of 400 volts for a period of time greater than a threshold period of time of 40 to 50 microseconds.

The clamp voltage may be determined by the IGBT internal zener diode breakdown voltage, and thus different IGBTs may have different clamp voltages. If the clamp voltage of another IGBT exceeds a higher threshold value of 500 volts, the threshold period of time before the delay voltage signal at node 54 exceeds 2.5 volts would be correspondingly shorter, such as 30 to 40 microseconds, for example. Conversely, if the clamp voltage had a lower value of 300 volts, i.e. exceeded a lower threshold value, the threshold period of time before the delay voltage signal at node 54 exceeds 2.5 volts would be correspondingly longer, such as 50 to 60 microseconds, for example. Thus, there may be an inverse relationship between the threshold value of the clamp voltage and the threshold period of time.

Microprocessor 66 may monitor the voltage at collector 32 via node 68, IGBT driver 42 and resistor 64 in order to detect faults associated with primary coil 18. Microprocessor 66 may also monitor the emitter current by measuring the voltage drop across resistor 40 as another way of detecting faults associated with primary coil 18.

Second end 26 of secondary coil 20 has been shown herein as being grounded. However, it is also possible for second end 26 to be electrically connected to second end 38 of primary coil 18.

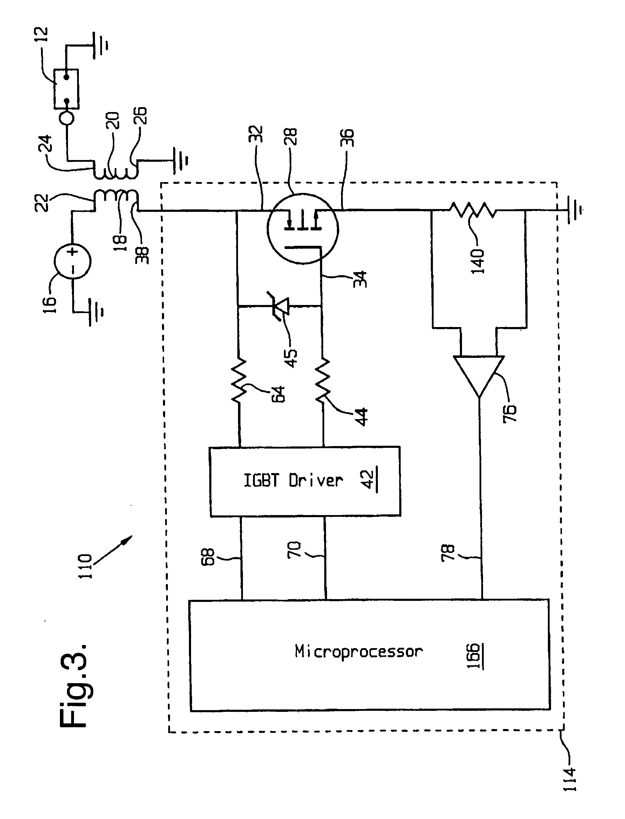

Figure 3 illustrates another embodiment of an electronic circuit 110 of the present invention for driving a load 12. Rather than monitoring the voltage at collector 32 to sense an open condition in secondary coil 20, circuit 110 monitors a current through primary coil 18 to sense an open condition in secondary coil 20. ECM 114 is similar to ECM 14 except that, instead of including a delay circuit and a comparator for monitoring the collector voltage, ECM 114 includes a differential amplifier 76 to monitor the emitter current through sense resistor 140 and translate the current into a voltage to be input into microprocessor 166 via node 78.

During use, power supply 16 applies a voltage to collector 32 through primary coil 18. Microprocessor 166 may selectively apply a voltage signal to gate 34 via IGBT driver 42 and resistor 44 to thereby selectively allow current to flow through IGBT 28. More particularly, the application of voltage to gate 34 may allow current to flow from collector 32 to emitter 36, and the absence of voltage at gate 34 may prevent current from flowing from collector 32 to emitter 36.

The flow of current through IGBT 28, in turn, allows current to flow through primary coil 18. Primary coil 18 and 20 form a transformer. The typical turns ratio of the transformer is in the order of 80 to 100. When the transistor 28 is switched OFF after reaching the energization current, say 10 Amperes, the primary coil 18 develops a kick back voltage in the order of 380 to 430 volts. If secondary coil 20 is in good condition, i.e., there are no electrical discontinuities between plug 12 and ground, the basic transformer action induces a secondary voltage at coil 20 corresponding to 80 to 100 times the voltage developed across primary coil 18. This high voltage may cause a spark across the spark plug. Thus, the current interruption within coil 18 may result in a spark at plug 12.

In contrast, if secondary coil 20 is not in good condition, but rather is in an open condition, current may flow through IGBT 28, and hence through sense resistor 140, at the same time that IGBT 28 is commanded to the OFF state by microprocessor 166. That is, when secondary coil 20 is in the open condition, current may flow through IGBT 28 simultaneously with an absence of voltage at gate 34. Thus, microprocessor 166 may monitor the voltages at gate 34 and node 78. If there is voltage at node 78 at the same time that no voltage is being applied to gate 34, microprocessor 166 may determine that secondary coil 20 is in an open condition, and may thereafter refrain from applying further pulses to gate 34 in order to protect IGBT 28 from damage.

In order to allow for response times, microprocessor 166 may require that the voltage at node 78 remain high for a predetermined time period after voltage has been removed from gate 34 before determining that there is an open condition at secondary coil 20. This may be accomplished via software within microprocessor 166. Alternatively, a discrete delay circuit may be included between amplifier 76 and microprocessor 166 within node 78.

While this invention has been described as having an exemplary design, the present invention may be further modified within the spirit and scope of this disclosure. This application is therefore intended to cover any variations, uses, or adaptations of the invention using its general principles. Further, this application is intended to cover such departures from the present disclosure as come within known or customary practice in the art to which this invention pertains.

## Claims

1. An electronic circuit (10) for driving a load (12), comprising:
a primary coil (18) coupled to a secondary coil (20), said secondary coil being configured to be coupled to the load;
a switching device (28) electrically connected to said primary coil; and
a control circuit (30) coupled to said switching device and configured to inhibit current flow through said switching device if an electrical signal applied to said switching device by said primary coil is indicative of said secondary coil being in an open condition.

2. The circuit of claim 1, wherein said switching device comprises a transistor.

3. The circuit of claim 2, wherein said transistor includes a collector (32) connected to said primary coil, an emitter (36) connected to electrical ground, and a gate (34) connected to said control circuit.

4. The circuit of claim 1, wherein the electrical signal comprises at least one of a voltage signal and a current signal.

5. The circuit of claim 1, wherein said control circuit is configured to inhibit current flow through said switching device if the electrical signal exceeds a threshold value for a period of time greater than a threshold period of time.

6. The circuit of claim 5, wherein said control circuit includes a delay circuit (46) configured to produce a delay voltage signal exceeding a threshold voltage if the electrical signal applied to said switching device exceeds the threshold value for a period of time greater than the threshold period of time.

7. The circuit of claim 6, wherein said delay circuit comprises a resistor capacitor circuit.

8. The circuit of claim 6, wherein said control circuit includes a comparator (56) configured to output a comparator signal if the delay voltage signal exceeds the threshold voltage.

9. The circuit of claim 8, wherein said control circuit includes a processor (66) configured to inhibit current flow through said switching device in response to receiving the comparator signal.

10. The circuit of claim 1, further comprising a power supply (16) electrically connected to a first end (22) of said primary coil, said switching device being electrically connected to a second end (38) of said primary coil.

11. An electronic circuit (10) for driving a load (12), comprising:
a primary coil (18) coupled to a secondary coil (20), said secondary coil being configured to be coupled to the load;
a switching device (28) electrically connected to said primary coil; and
a control circuit (30) configured to:
monitor at least one of a voltage and a current applied to said switching device by said primary coil; and
inhibit current flow through said switching device if said at least one of a voltage and a current exceeds a threshold value for a period of time greater than a threshold period of time.

12. The circuit of claim 11, wherein said switching device comprises a transistor.

13. The circuit of claim 12, wherein said transistor includes a collector (32) connected to said primary coil, an emitter (36) connected to electrical ground, and a gate (34) connected to said control circuit.

14. The circuit of claim 11, wherein said at least one of a voltage and a current exceeding a threshold value for a period of time greater than a threshold period of time is indicative of said secondary coil being in an open condition.

15. The circuit of claim 11, wherein said control circuit includes a delay circuit (46) configured to produce a delay voltage signal exceeding a threshold voltage if said at least one of a voltage and a current exceeds the threshold value for a period of time greater than the threshold period of time.

16. The circuit of claim 15, wherein said delay circuit comprises a resistor capacitor circuit.

17. The circuit of claim 15, wherein said control circuit includes a comparator (56) configured to output a comparator signal if the delay voltage signal exceeds the threshold voltage.

18. The circuit of claim 17, wherein said control circuit includes a processor (66) configured to inhibit current flow through said switching device in response to receiving the comparator signal.

19. The circuit of claim 17, wherein said control circuit includes a voltage divider (50, 52) configured to reduce a voltage level of the delay voltage signal.

20. The circuit of claim 11, further comprising a power supply (16) electrically connected to a first end (22) of said primary coil, said switching device being electrically connected to a second end (38) of said primary coil.
